**Europäisches Patentamt**

**European Patent Office**

**Office européen des brevets**

(19)

(11) Veröffentlichungsnummer: **0 149 095**
**B1**

(12) # EUROPÄISCHE PATENTSCHRIFT

(45) Veröffentlichungstag der Patentschrift:
**23.11.88**

(21) Anmeldenummer: **84114707.7**

(22) Anmeldetag: **04.12.84**

(51) Int. Cl.⁴: **G 01 R  27/28,** H 04 B  3/48,
G 01 R  31/28, G 01 R  19/00

(54) **Verfahren zur Prüfung pegelabhängiger Eigenschaften von Übertragungseinrichtungen, insbesondere der pegelabhängigen Dämpfungsverzerrung von Codecs für PCM-Geräte, sowie Vorrichtung zur Durchführung des Verfahrens.**

(30) Priorität: **07.12.83  DE 3344251**

(43) Veröffentlichungstag der Anmeldung:
**24.07.85 Patentblatt 85/30**

(45) Bekanntmachung des Hinweises auf die Patenterteilung:
**23.11.88 Patentblatt 88/47**

(84) Benannte Vertragsstaaten:
**AT BE CH DE GB IT LI**

(56) Entgegenhaltungen:
**DE-A-2 724 991
DE-B-2 926 281

THE RADIO AND ELECTRONIC ENGINEER, Band 50,
Nr. 7, Juli 1980, Seiten 353-362, Institution of
Electronic and Radio Engineers, London, GB; R.G.
ROLLS: "A review of distortion and its
measurement in p.c.m. telephony systems"
FREQUENZ, Band 28, Nr. 10, 1974, Seiten 270-274;
H.H. FREYTAG: "Messgeräte für PCM-Digital-
Übertragungssysteme"**

(73) Patentinhaber: **Siemens Aktiengesellschaft Berlin
und München, Wittelsbacherplatz 2, D-8000
München 2 (DE)**

(72) Erfinder: **Kimmel, Siegfried, Dipl.- Ing., Kemptener
Strasse 54, D-8000 München 71 (DE)**

## Beschreibung

Die Erfindung betrifft ein Verfahren der im Gattungsbegriff des Patentanspruches 1 beschriebenen Art, sowie eine Vorrichtung zur Durchführung desselben.

Durch die Verfügbarkeit hochentwickelter und preiswerter Digitalbausteine, sowie die Einführung breitbandiger Übertragungskanäle in Lichtwellenleiter-Technologie, können die Vorteile der digitalen Nachrichtenübertragung und -vermittlung, beispielsweise die beiliebige Regenerierbarkeit der Signale und die Möglichkeit ihrer Be- und Verarbeitung mit den Mitteln der modernen Computertechnologie, für neue Anwendungsgebiete genutzt werden. Die hohen Qualitätsanforderungen und großen Stückzahlen der verwendeten Bauteile und Baugruppen rücken das Problem der Funktionsprüfung, beispielsweise zur Fertigungskontrolle, immer mehr in den Vordergrund. Diese hat möglichst rasch über eine Vielzahl von Eigenschaften der Übertragungseinrichtungen Aufschluß zu geben.

Zu den wichtigsten Bauteilen der digitalen Nachrichtenübertragungstechnik gehören Digital Analog und/oder Analog-Digital-Wandler bzw. Bauteile, die diese enthalten. Ein Beispiel dafür stellt der PCM-Codec dar.

Die Fertigungskontrolle soll nicht nur genauen Aufschluß über die Qualifikation des jeweils geprüften Exemplares geben, sondern auch Rückschlüsse auf systematische Fertigungsmängel zulassen. Die Prüfung digitaler Wandlerbausteine mit Hilfe herkömmlicher Übertragungsmeßplätze erfordert vergleichsweise lange Meß- und Prüfzeit. Dabei interessiert neben der Quantisierungsverzerrung die Dämpfungsverzerrung. Es sei um Mißverständnissen vorzubeugen darauf hingewiesen, daß es sich bei der in der Literatur mit Dampfungsverzerrung bezeichneten Größe meist um die sogenannte frequenzabhängige Dämpfungsverzerrung handelt. Daneben ist aber insbesondere auch die pegelabhängige Dämpfungsverzerrung von Interesse. Hierbei handelt es sich um eine amplitudenabhängige, nichtlineare Verzerrung des übertragenen Signals.

Einen Überblick über Meßgrößen in der Datenübertragungstechnik bringt G. Kafka in "Meßtechnik in der Datenkommunikation" der Zeitschrift Elektronik Nr. 8/1982, Seiten 121 - 129. Hier wird, wie auch in den folgenden Publikationen, auf die große Zeitersparnis hingewiesen, die durch Einsatz von Prüfverfahren, die sich der sogenannten Fourier-Transformation bedienen, erzielt werden kann. Im Speziellen handelt es sich um diskrete Fourier-Transformation und deren besonderes Rechenverfahren, die Fast-Fourier-Transformation (FFT). Siehe dazu auch A. Wehringer "Grundlagen und Realisierung der FFT" in Elektronikschau, Heft 1, Heft 2/1980. Gegen die weitverbreitete Anwendung sprechen der relativ hohe Rechenaufwand, sowie die Schwierigkeit, die Meßergebnisse exakt zu deuten. Auch in dem Artikel von G. Bläß "Meßverfahren zur Bestimmung von Pegel und Gruppenlaufzeit" in NTZ Band 34 (1981), Heft 1 wird auf die Problematik der Anwendung der FFT in der Praxis hingewiesen. Die Firma Fairchild erzeugt einen Testadapter, mit dem es möglich ist, sie bei Prüfverfahren zu nützen. Erst durch einen Array-Processor ist das Testergebnis in relativ kurzer Zeit vom Zeit- in den Frequenzbereich transformierbar. Bei allen im Zusammenhang mit FFT beschriebenen Meßgrößen handelt es sich aber ausschließlich um frequenzabhängige. Eine allfällige Pegelabhängigkeit wird bisher lediglich durch eine entsprechende Anzahl von Einzelmessungen des Prüfsignales mit unterschiedlichen Amplituden festgestellt. Andere Möglichkeiten des Tests vom PCM-Codecs werden von R.G. Rolls in "The Radio and Electronic Engineer", Vol 50, No. 7, July 1980 unter dem Titel "A review of distortion and its measurement in p.c.m. telephony systems" beschrieben. Hier werden die Ergebnisse bei unterschiedlichen Prüfsignalen verglichen. Es werden Sinussignale ebenso wie Rauschsignale und Pseudorauschsignale verwendet. Es wird vor allem auf die Quantisierungsverzerrung eingegangen. Weiters ist ein Verfahren bekannt (EP-A-0 069 398), das durch quasi stroboskopische Abtastung die Gesamtheit der Antwort des Prüflings auf das Meßsignal beliebig genau beschreibt. Aus dieser werden anschließend durch Vergleich mit dem Ausgangssignal die gewünschten, im speziellen auch pegelabhängigen, Meßgrößen ermittelt.

Der Erfindung liegt die Aufgabe zugrunde, bei Verfahren der im Gattungsbegriff des Patentanspruches 1 beschriebenen Art die Meßzeit weiter herabzusetzen. Das Verfahren gemäß der Erfindung ist durch die im Patentanspruch 1 beschriebenen Verfahrensschritte gekennzeichnet.

Vorteilhafte Ausgestaltungen des Verfahrens gemäß der Erfindung, sowie eine Vorrichtung zur Durchführung dieses Verfahrens sind Gegenstand der Unteransprüche, auf die hiermit zur Verkürzung der Beschreibung ausdrücklich verwiesen wird.

Ein anderes Meßverfahren zur Ermittlung der Dämpfungsverzerrung und der Gruppenlaufzeitverzerrung eines Meßobjekts, z. B. einer Nachrichtenübertragungsstrecke ist aus der DE-A-2 724 991 bekannt. Zur Durchführung dieses Verfahrens wird dem Meßobjekt ein Testimpuls zugeführt und eine durch das Meßobjekt verursachte Verformung ausgewertet, wobei der Testimpuls aus einer Reihe bezüglich ihrer Amplitude und Phase vorgegebener Schwingungen unterschiedlicher Frequenz besteht und wobei mit Hilfe der Fourier-Analyse die Impulsantwort zerlegt und die einzelnen Frequenzkomponenten hinsichtlich ihrer Amplituden und ihrer Phasenbeziehung zueinander bestimmt werden.

Das Verfahren gemäß der Erfindung ermöglicht die Prüfung nicht nur von A/D- und/oder D/A-Wandlern, sondern auch von Übertragungselementen oder -abschnitten. Das können entweder die mit einem solchen Wandler verbundenen bzw. nicht getrennt zugänglichen Filter sein, oder auch ganze Übertragungsabschnitte und dergleichen. Die Wandler können entweder in Kombination mit derartigen Übertragungsabschnitten geprüft werden, so daß sich das Verhalten der aus Wandler und beispielsweise Leitungsabschnitt bestehenden Gesamtanordnung ermitteln läßt, oder aber es können die Eigenschaften von Übertragungsabschnitten oder allgemein von Vierpolen für sich ermittelt werden.

Der grundlegende Erfindungsgedanke liegt in der Verwendung eines an sich bekannten mathematischen Verfahrens (der Fast-Fourier-Transformation), das bisher nur zur Bestimmung frequenzabhängiger Größen verwendet wird. Nunmehr ist es möglich, es auch zur Messung amplitudenabhängiger Größen heranzuziehen. Um dieses Verfahren anwenden zu können, muß das Prüfsignal so schmalbandig gewählt werden, daß in diesem Bereich die Meßgröße nahezu frequenzunabhängig ist. Dies wird anhand der pegelabhängigen Dämpfungsverzerrung von Codecs zur Pulscodemodulation und folgender Figuren deutlich gemacht.

Fig. 1   zeigt ein mögliches Frequenzspektrum für ein Multifrequenz-Testsignal zur Messung der pegelabhängigen Dämpfungsverzerrung von PCM-Codecs.

Fig. 2   zeigt das Meßergebnis des in Fig. 1 angegebenen Frequenzspektrums im Toleranzfeld der pegelabhängigen Dämpfungsverzerrung.

Fig. 3   zeigt das Blockschaltbild einer Anordnung zur Messung eines Prüflings in Analog-Digital-Richtung.

Fig. 4   zeigt das Blockschaltbild einer Anordnung zur Messung eines Prüflings in Digital-Analog-Richtung.

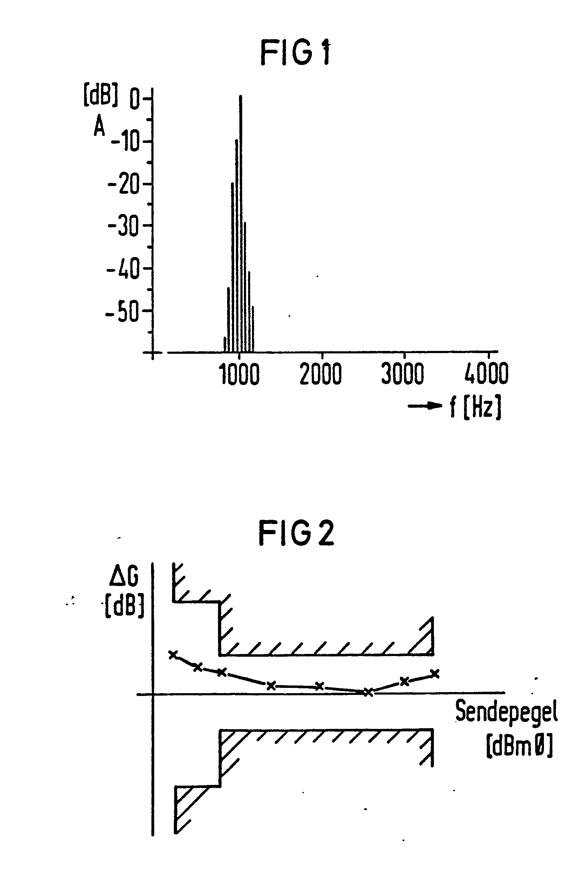

An diesem Beispiel wird der Ablauf des erfindungsgemäßen Verfahrens gezeigt. Das Übertragungsverhalten bei acht unterschiedlichen Pegeln ist gleichzeitig zu prüfen. Daher wird das Prüfsignal von acht Sinusschwingungen eng benachbarter Frequenzen aufgebaut. Ihre Amplituden werden entsprechend den Pegeln eingestellt. Es ist wichtig, daß die Frequenzen der einzelnen Signalkomponenten so nahe benachbart sind, daß sie insgesamt ein quasi monofrequentes Prüfsignal bilden, d.h. ein Signal, in dessen Frequenzbereich die Frequenzabhängigkeit der zu bestimmenden Größe praktisch vernachlässigbar ist. Andererseits muß aber auch auf die Notwendigkeit der späteren Separierbarkeit zur Analyse der Komponenten geachtet werden. Vorzugsweise wird eine besonders charakteristische Frequenz des Prüflings mit dem größten Teilpegel beaufschlagt. Ein Vorschlag zur Gestaltung des Prüfsignals zeigt das in Fig. 1 abgebildete Frequenzspektrum. Die Signalkomponenten gruppieren sich um die für Codecs übliche Prüffrequenz von 1.000 Hz. Die Abstände zwischen ihnen betragen jeweils 10 Hz. Durch die geeignete Wahl von Frequenz und Phasenlage wird berücksichtigt, daß einerseits der Kanal nicht übersteuert wird, andererseits ein Frequenzspektrum mit scharfen Spektrallinien entsteht und es während der Meßzeit zu keinen das Ergebnis verfälschenden Schwebungserscheinungen kommt. Das resultierende Antwortsignal wird mittels Fourier-Transformation analysiert und liefert gleichzeitig die Dämpfungsverzerrung jedes eingestellten Pegelpunktes für eine andere der eng benachbarten Frequenzen. Hieraus kann durch eine nachfolgende Rechenoperation die gewünschte Pegelabhängigkeit der Dämpfungsverzerrung gewonnen werden. Der Meßfehler, der durch diesen Kunstgriff entsteht, ist im allgemeinen vernachlässigbar klein, da die frequenzabhängige Dämpfungsverzerrung in dem interessierenden Meßbereich außerordentlich flach verläuft. Eventuell nötige Korrekturen als Folge des Frequenzganges sind durch die ohnehin nötige Messung der frequenzabhängigen Dämpfungsverzerrung ohne besonderen zusätzlichen Aufwand möglich. Die Verkürzung der Meßzeit gegenüber herkömmlichen Meßmethoden entspricht mindestens der Anzahl der gleichzeitig verarbeiteten Pegel. Sie wird in diesem Beispiel auf ein Achtel herabgesetzt. In Fig. 2 ist das Meßergebnis im Toleranzfeld der pegelabhängigen Dämpfungsverzerrung dargestellt.

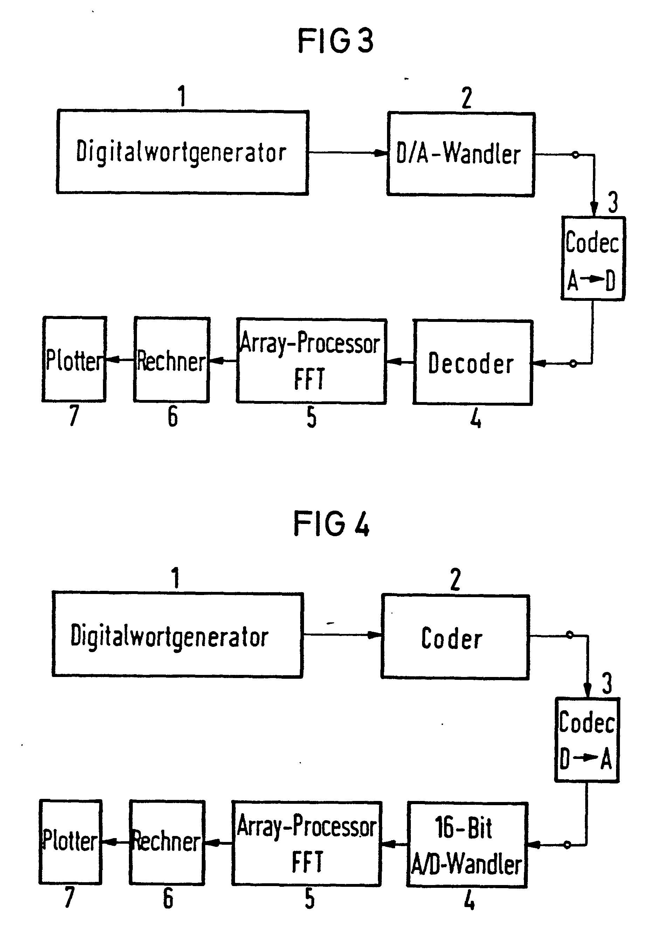

Eine Vorrichtung zur Durchführung des erfindungsgemäßen Verfahrens zeigt das in Fig. 3 dargestellte schematische Blockschaltbild. Es wird ein 8-Bit Codec in Analog-Digital-Richtung geprüft. Ein Digitalwortgenerator 1 erzeugt eine, das Prüfsignal beschreibende Wortfolge, die anschließend einem hochgenauen Digital-Analog-Wandler 2 zugeführt wird, dessen Ausgang mit dem Analog-Eingang des Codecs 3 verbunden ist. Die von diesem gewandelte Prüfantwort muß decodiert werden 4, bevor sie dem Array-Processor 5 zur Fast-Fourier-Transformation zugeführt wird. Ein Rechner 6 analysiert das Ergebnis und gibt es beispielsweise über einen Plotter 7 aus.

Die Überprüfung des Codecs in Digital-Analog-Richtung wird in Fig. 4 dargestellt. Wieder erzeugt ein Digitalwortgenerator 1 eine Beschreibung des Prüfsignals, die gegebenenfalls in einem PCM-Coder 2 umgewandelt und dem Digital-Eingang des Codecs 3 zugeführt wird. Dessen Prüfantwort wird mit Hilfe eines 16-Bit Analog-Digital-Konverters 4 umgewandelt und einem Array-Processor 5 zur Fast-Fourier-Transformation zugeführt. Rechner 6 und Plotter 7 sorgen wieder für die Ausgabe des Prüfergebnisses.

Es gibt grundsätzlich zwei Testphilosophien. Die eine gibt analogen Verfahren den Vorzug, während sich die andere auf die Digitaltechnik beschränkt. Obwohl hier ein Digitalverfahren beschrieben wurde, ist es selbstverständlich auch möglich, diesen Test in hochgenauer Analogtechnik durchzuführen. Der Digitaltechnik ist sowohl der Vorzug zu geben, da bei dem erfindungsgemäßen Verfahren eine rechnergestützte Auswertung des Meßergebnisses unerlässlich ist. Außerdem ist der Aufwand zur Erzielung einer hohen Präzision und genauen Reproduzierbarkeit der Ergebnisse geringer. Beispielsweise gibt es beim Digitalwortgenerator 1 keine Einschwingvorgänge und er liefert auch die Beschreibung des Prüfsignales im PCM-Code, wenn dies erforderlich ist. Es wird aber ausdrücklich auf den Unteranspruch 11 verwiesen, da es sehr wohl auch möglich ist das Prüfsignal auf analogem Wege zu erzeugen, ohne das Verfahren gemäß der Erfindung grundlegend zu verändern.

**Patentansprüche**

1. Verfahren zur Prüfung pegelabhängiger Eigenschaften von Übertragungseinrichtungen, insbesondere der pegelabhängigen Dämpfungsverzerrung von Codecs für PCM-Geräte, dadurch gekennzeichnet, daß in den Prüfling ein Prüfsignal eingespeist wird, das aus Schwingungen eng benachbarter, separierbarer Frequenzen als Signalkomponenten besteht, oder solchen Schwingungen entspricht, in deren Bereich die zu prüfenden pegelabhängigen Eigenschaften zumindestens annähernd konstant bleiben und dessen Signalkomponenten unterschiedliche Pegel aufweisen, daß ferner die Prüfantwort vom Zeit- in den Frequenzbereich transformiert und das Ergebnis im Bereich des Prüsignals mit diesem in Beziehung gesetzt wird.

2. Verfahren nach Anspruch 1, dadurch gekennzeichnet, daß das Prüfsignal bezüglich der Frequenzen seiner Signalkomponenten um eine charakteristische Frequenz des Prüflings gelegt wird, wobei der größte Teilpegel auf eben diese Frequenz entfällt.

3. Verfahren nach Anspruch 1 oder 2, dadurch gekennzeichnet, daß durch den Vergleich der Pegel der Signalkomponenten des Prüfsignals mit den jeweils entsprechendender Prüfantwort die pegelabhängige Dämpfungsverzerrung bestimmt wird.

4. Verfahren nach Anspruch 1, dadurch gekennzeichnet, daß ein neues Signal, bestehend aus mehreren der im Anspruch 1 charakterisierten Prüfsignale, die über das zu übertragende Frequenzband verteilt sind, in den Prüfling eingespeist wird und daß durch die auf diese Art gewonnene Prüfantwort bei einer einzigen Messung die pegelabhängige und die frequenzabhängige Dämpfungsverzerrung bestimmt werden.

5. Verfahren nach einem der vorhergehenden Ansprüche, dadurch gekennzeichnet, daß die Anfangsphasen der Signalkomponenten so gelegt werden, daß während der, für eine Messung erforderlichen Zeitspanne, keine störenden Schwebungserscheinungen und/oder Übersteuerungen auftreten.

6. Verfahren nach einem der vorhergehenden Ansprüche, dadurch gekennzeichnet, daß zur Transformation der Prüfantwort vom Zeit- in den Frequenzbereich die Fast-Fourier-Transformation (FFT) zur Anwendung kommt.

7. Verfahren nach Anspruch 7, dadurch gekennzeichnet, daß die Periodizitätsbedingung der FFT durch geeignete Festlegung des Anfangs - und Endzeitpunktes der Meßaufzeichnung der Prüfantwort erfüllt wird.

8. Verfahren nach einem der vorhergehenden Ansprüche, dadurch gekennzeichnet, daß das in Anspruch 1 charakterisierte Prüfsignal durch Sinusschwingungen dargestellt wird.

9. Verfahren nach einem der vorhergehenden Ansprüche, dadurch gekennzeichnet, daß eine etwaige frequenzabhängige Dämpfungsverzerrung des Meßergebnisses entsprechend dem Ergebnis einer nachfolgenden Messung der frequenzabhängigen Übertragungseigenschaften der Übertragungseinrichtungen korrigiert wird.

10. Vorrichtung zur Durchführung des Verfahrens nach einem der vorhergehenden Ansprüche, gekennzeichnet durch
- einen Digitalwortgenerator zur Erzeugung einer das dem jeweiligen Verfahren zugeordnete Prüfsignal beschreibenden digitalen Wortfolge,
- einen hochgenauen Digital-Analog-Wandler zur Umsetzung dieser Wortfolge in das Prüfsignal, dessen Ausgang mit einem Analog-Eingang des Prüflings verbunden ist und
- einen Array-Processor, dessen Eingang mit einem Digital-Ausgang des Prüflings verbunden ist, und der die Prüfantwort fast-fouriertransformiert, worauf durch Vergleich des Ergebnisses mit dem Prüfsignal die pegelabhängige Dämpfungsverzerrung, sowie gegebenenfalls auch die frequenzabhängige Dämpfungsverzerrung ermittelt wird.

11. Vorrichtung nach Anspruch 10, gekennzeichnet durch
- einen Funktionsgenerator zur Erzeugung des analogen Prüfsignals, der mit dem Analog-Eingang des Prüflings verbunden ist.

12. Vorrichtung zur Durchführung des Verfahrens nach einem der Ansprüche 1 bis 9, <u>gekennzeichnet durch</u>
- einen Digitalwortgenerator zur Erzeugung einer, das dem jeweiligen Verfahren zugeordnete Prüfsignal beschreibenden digitalen Wortfolge, dessen Ausgang mit einem Digital-Eingang des Prüflings verbunden ist,
- einen hochgenauen Analog-Digital-Wandler, dessen Analog-Eingang mit einem Analog-Ausgang des Prüflings verbunden ist und
- einen Array-Processor, dessen Eingang mit dem Digital-Ausgang des Wandlers verbunden ist, und der die Prüfantwort fast-fouriertransformiert, worauf durch Vergleich des Ergebnisses mit dem Prüfsignal die pegelabhängige Dämpfungsverzerrung, sowie gegebenenfalls auch die frequenzabhängige Dämpfungsverzerrung ermittelt wird.

## Claims

1. A method of testing level-dependent characteristics of transmission devices, in particular the level-dependent attenuation distortion of codes for PCM-devices, <u>characterised in</u> that into the test item there is fed a test signal which comprises oscillations of closely adjacent, separable frequencies as signal components or which corresponds to oscillations in the range of which the level-dependent characteristics which are to be tested remain at least approximately constant and whose signal components possess different levels, that moreover the test response is transformed from the time domain into the frequency domain and the result is related to the test signal in the region thereof.

2. A method as claimed in claim 1, <u>characterised in</u> that the frequencies of the signal components of the test signal are set so as to occur around a characteristic frequency of the test item, where the maximum sub-level is assigned to precisely this frequency.

3. A method as claimed in claim 1 or claim 2, <u>characterised in</u> that the level-dependent attenuation distortion is determined by comparing the levels of the signal components of the test signal with the respective corresponding levels of the test response.

4. A method as claimed in claim 1, <u>characterised in</u> that a new signal, comprising a plurality of the test signals characterised in claim 1, which are distributed over the frequency band which is to be transmitted, are fed into the test item and that by the test response obtained in this way, in one single measurement, the level-dependent and frequency-dependent attenuation distortion is determined.

5. A method as claimed in one of the preceding claims, <u>characterised in</u> that the starting phases of the signal components are contrived to be such that during the time interval required for a measurement no disturbing beat phenomena and/or overloads occur.

6. A method as claimed in one of the preceding claims, <u>characterized in</u> that fast-Fourier-transformation (FFT) is used to transform the test response from the time domain into the frequency domain.

7. A method as claimed in claim 6, <u>characterized in</u> that the periodicity condition of the FFT is fulfilled by a suitable specification of the starting time and ending time of the measurement recording of the test response.

8. A method as claimed in one of the preceding claims, <u>characterised in</u> that the test signal characterised in claim 1 is represented by sine oscillations.

9. A method as claimed in one of the preceding claims, characterized in that any frequency-dependent attenuation distortion of the measurement result is corrected in accordance with the result of a subsequent measurement of the frequency-dependent transmission characteristics of the transmission devices.

10. A device for implementing the method claimed in one of the preceding claims, <u>characterised by</u>
- a digital word generator which generates a digital word sequence which describes the test signal assigned to the respective process,
- a high-accuracy digital-analogue converter which converts the test signal and whose output is connected to an analogue-input of the test item, and
- an array processor whose input is connected to a digital-output of the test item and which fast-Fourier-transforms the test response whereupon, by comparing the result with the test signal, the level-dependent attenuation distortion, and where appropriate also the frequency-dependent attenuation distortion, are determined.

11. A device as claimed in claim 1, <u>characterized by</u>
- a function generator which generates the analogue test signal and which is connected to the analogue-input of the test item.

12. A device for implementing the method claimed in one of the claims 1 to 9, <u>characterised by</u>
- a digital word generator which generates a digital word sequence descriptive of the test signal assigned to the respective process, and whose output is connected to a digital-input of the test item,
- a high-accuracy analogue-digital converter whose analogue-input is connected to an analogue-output of the test item,
- an array processor whose input is connected to the digital output of the converter and which fast-Fourier-transforms the test response whereupon, by comparing the result with the test signal, the level-dependent attenuation distortion, and where appropriate also the frequency-dependent attenuation distortion, are determined.

**Revendications**

1. Procédé pour contrôler des propriétés, qui dépendent du niveau, de dispositifs de transmission, notamment des distorsions d'affaiblissement, qui dépendent du niveau, de codecs pour des appareils MIC, caractérisé par le fait qu'on introduit dans l'élément à contrôler un signal de contrôle qui est constitué par des oscillations possédant des fréquences séparables étroitement voisines, en tant que composantes du signal, ou correspond à des oscillations, dans la plage desquelles les propriétés devant être contrôlées, qui dépendent du niveau, restent au moins approximativement constantes et dont les composantes du signal possèdent des niveaux différents, qu'en outre on transforme la réponse de contrôle de la plage temporelle dans la plage des fréquences et qu'on met en rapport le résultat avec le signal de contrôle, dans la plage de ce signal.

2. Procédé suivant la revendication 1, caractérisé par le fait que les fréqences des composantes du signal de contrôle sont disposées autour d'une fréquence caractéristique de l'élément à contrôler, le niveau partiel maximum apparaissant précisément à cette fréquence.

3. Procédé suivant la revendication 1 ou 2, caractérisé par le fait qu'on détermine la distorsion d'affaiblissement, qui dépend de la fréquence, au moyen de la comparaison des niveaux des composantes du signal de contrôle avec les composantes correspondantes respectives de la réponse du signal.

4. Procédé suivant la revendication 1, caractérisé par le fait qu'on introduit dans l'élément à contrôler un nouveau signal constitué par plusieurs des signaux de contrôle caractérisés dans la revendication 1 et répartis dans la bande de fréquences devant être transmise, et qu'on détermine la distorsion d'affaiblissement, qui dépend du niveau, et la distorsion d'affaiblissement, qui dépend de la fréquence, au moyen de la réponse de contrôle obtenue de cette manière, en une seule mesure.

5. Procédé suivant l'une des revendications précédentes, caractérisé par le fait que les phases initiales des composantes du signal sont situées de telle manière que pendant l'intervalle de temps nécessaire pour une mesure, il n'apparaît aucun phénomène nuisible de battement et/ou aucune surmodulation.

6. Procédé suivant l'une des revendications précédentes, caractérisé par le fait que pour la transformation de la réponse de contrôle de la plage temporelle à la plage des fréquences, on met en oeuvre la transformation de Fourier rapide (FFT).

7. Procédé suivant la revendication 7, caractérisé par le fait que la condition de périodicité de la transformation FFT est satisfaite au moyen de la détermination appropriée de l'instant de démarrage et de l'instant d'arrêt de l'enregistrement de mesure de la réponse de contrôle.

8. Procédé suivant l'une des revendications précédentes, caractérisé par le fait qu'un signal de contrôle caractérisé dans la revendication 1 est représenté par des oscillations sinusoïdales.

9. Procédé suivant l'une des revendications précédentes, caractérisé par le fait qu'on corrige une éventuelle distorsion d'affaiblissement, qui dépend de la fréquence, du résultat de mesure conformément au résultat d'une mesure ultérieure des propriétés de transmission, qui dépendent de la fréquence, des dispositifs de transmission.

10. Dispositif pour la mise en oeuvre du procédé suivant l'une des revendications précédentes, caractérisé par
- un générateur de mots numériques servant à produire une suite numérique de mots décrivant le signal de contrôle associé au procédé respectif,
- un convertisseur numérique/analogique de grande précision, qui sert à convertir cette suite de mots en le signal de contrôle et dont la sortie est reliée à une entrée analogique de l'élément à contrôler, et
- un processeur vectoriel, dont l'entrée est reliée à une sortie numérique de l'élément à contrôler et qui transforme au moyen d'une transformation de Fourier rapide la réponse de contrôle, à la suite de quoi la distorsion d'affaiblissement, qui dépend du niveau, ainsi qu'éventuellement également la distorsion d'affaiblissement, qui dépend de la fréquence, sont déterminées par comparaison du résultat avec le signal de contrôle.

11. Dispositif suivant la revendication 10, caractérisé par
- un générateur de fonctions, qui sert à produire le signal de contrôle analogique et est relié à l'entrée analogique de l'élément à contrôler.

12. Dispositif pour la mise en oeuvre du procédé suivant l'une des revendications 1 à 9, caractérisé par
- un générateur de mots numériques servant à produire la suite numérique de mots décrivant le signal de contrôle associé au procédé respectif,
- un convertisseur numérique/analogique de grande précision, qui sert à convertir cette suite de mots en le signal de contrôle et dont la sortie est reliée à une entrée analogique de l'élément à contrôler, et
- un processeur vectoriel, dont l'entrée est reliée à une sortie numérique de l'élément à contrôler et qui transforme au moyen d'une transformation de Fourier rapide la réponse de contrôle, à la suite de quoi la distorsion d'affaiblissement, qui dépend du niveau, ainsi qu'éventuellement également la distorsion d'affaiblissement, qui dépend de la fréquence, sont déterminées par comparaison du résultat avec le signal de contrôle.

# FIG 1

# FIG 2

0 149 095

## FIG 3

## FIG 4